# EUROPEAN PATENT SPECIFICATION

(11) **EP 1 989 739 B1**
(45) Date of publication and mention of the grant of the patent: **21.11.2018**
(21) Application number: 07757028.1
(22) Date of filing: 15.02.2007
(51) Int. Cl.: H01L 25/065, H01L 25/10

(54) **MULTIPLE DIE INTEGRATED CIRCUIT PACKAGE AND MANUFACTURING METHOD**
INTEGRIERTE SCHALTUNG MIT MEHREREN CHIPS UND HERSTELLUNGSVERFAHREN
BOITIER DE CIRCUIT INTEGRE A PUCES MULTIPLES ET PROCÉDÉ DE FABRICATION

(30) Priority: 15.02.2006 US 773719 P; 19.10.2006 US 583296
(43) Date of publication of application: 12.11.2008
(73) Proprietor: Texas Instruments Incorporated, Dallas, TX 75265-5474 (US)
(72) Inventor: LYNE, Kevin, Peter, Fairview, TX 75069 (US)
(74) Representative: Zeller, Andreas
(86) International application number: PCT/US2007/062182
(87) International publication number: WO 2007/095604

(56) References cited:
- WO-A2-2004/034433
- US-A1- 2004 262 734
- US-B2- 6 706 557

## Description

The invention relates generally to the field of semiconductor device assembly and packaging; and, more specifically, to semiconductor devices with multiple dies in the same packaging structure.

### BACKGROUND

It is well known that the consumers of the next generation electronic devices are demanding increased functions and features that are packed in a smaller size, consuming less power, and costing less than the earlier generation. Semiconductor device manufacturers are responding by incorporating improved three dimensional packaging technologies, such as systems in package (SiP), Multi-Chip Packages (MCPs), Package-on-Package (PoP), and similar others, that provide vertical stacking of one or more dies and/or packages that are integrated to operate as one semiconductor device.

PoP typically includes two semiconductor packages that are stacked on top of one another, and may be commonly used in products desiring efficient access to memory while reducing size, such as cellular telephones. Thus, PoP is a well known packaging technique to vertically combine two IC chips such as a logic chip, and a memory chip electrically coupled by ball grid arrays (BGAs) or similar other. However, many of the top packages are custom designed and often have unique and restricted footprints. As such, the top package may not be able to take advantage of low cost, commodity, off-the-shelf IC chips offering a standard, full matrix footprint. US 2004/262734 A1 and WO 2004/034433 A2 both disclose MCP and PoP packages.

### SUMMARY

Applicant recognizes an existing need for an improved method and system for fabricating a semiconductor device using a package-on-package (PoP) type packaging; the need for providing a PoP package having a combined height that is less than a desirable value; and the need for providing a top package of the PoP type that may be purchased as a commodity product having a full matrix footprint, absent the disadvantages found in the prior techniques discussed above.

The foregoing need is addressed by a semiconductor device having a package on package structure according to claim 1 and a method for fabricating a semiconductor device having a package on package structure according to claim 8. According to one embodiment, in a method and system for fabricating a semiconductor device having a package-on-package structure, a bottom laminate substrate (BLS) is formed to include interconnection patterns (IP) coupled to a plurality of conductive bumps (PCB). A top substrate (TS) is formed to mount a top package by forming a polyimide tape (PT) affixed to a metal layer (ML), and a top die attached to the ML on an opposite side as the PT. A laminate window frame (LWF), which may be a part of the BLS, is fabricated along a periphery of the BLS to form a center cavity. The center cavity enclosed by the BLS, the LWF and the TS houses the top die affixed back-to-back to a bottom die that is affixed to the BLS. The IP formed in the BLS and the LWS provide the electrical coupling between the ML, the top and bottom dies, and the PCB.

In one aspect of the disclosure, a method for fabricating a semiconductor device having a package-on-package structure includes forming a bottom laminate substrate, which includes interconnection patterns coupled to a plurality of conductive bumps. A laminate window frame is formed along a periphery of the bottom laminate substrate to form a center cavity. At least one die is attached to the bottom laminate substrate within the center cavity by a die attach compound. The center cavity is filled with a polymeric compound to protect the at least one die. A top substrate is formed as a receptor to mount a top package. The top substrate, which includes a polyimide tape affixed to a metal layer by an adhesive layer disposed in-between, is connected to the laminate window frame by a conductive connection, thereby enabling electrical coupling between the top metal layer and the at least one die.

Several advantages are achieved by the method and system according to the illustrative embodiments presented herein. The embodiments advantageously provide an improved PoP structure by providing a thin and cost-effective polyimide tape as a receptor for mounting a top package, and a bottom laminate substrate in the bottom package. The center cavity of the bottom package is advantageously capable of compactly housing a bottom die affixed back-to-back to a top die, the bottom and top dies being respectively attached to the bottom and top substrates. The dies may be connected to the substrate via wire bonding and/or flip chip technologies. Vias or holes formed in the polyimide tape advantageously lower the profile of the top package by providing a recess for a solder ball of the top package while providing support for the edge of the solder ball. The top package may be advantageously purchased as a commodity memory package having a standard full matrix footprint. The improved PoP structure also advantageously accommodates top packages, with each package having two dies and having varying body sizes, while minimizing the overall height.

### BRIEF DESCRIPTION OF THE DRAWINGS

FIG. 1A illustrates a simplified and schematic cross section of a semiconductor device having a package-on-package structure, according to the invention;
FIG. 1B additional details of a cross section of a bottom package of a semiconductor device described with reference to FIG. 1A;
FIG. 1C illustrates additional details of a cross section of a top package mounted on a bottom package of a semiconductor device described with reference to FIGS. 1A and 1B; and
FIG. 2 is a flow chart illustrating a method for fabricating a semiconductor device having a package-on-package structure.

### DETAILED DESCRIPTION OF EXAMPLE EMBODIMENTS

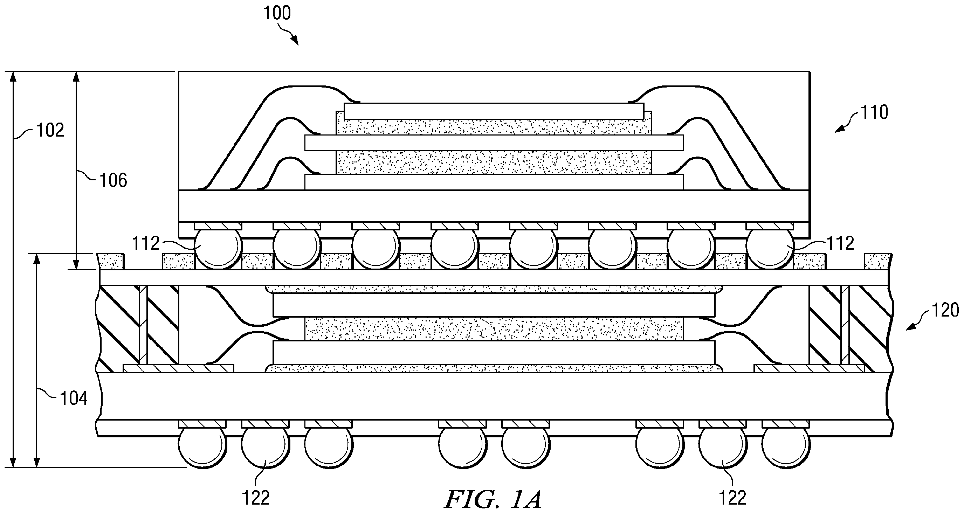

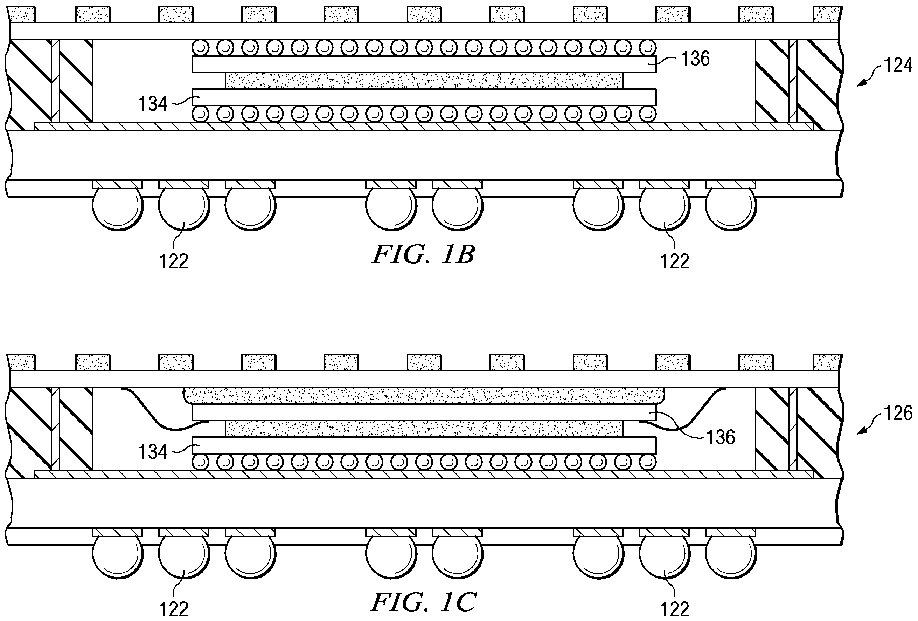

Traditional tools and methods for fabricating a semiconductor device having a PoP structure may be limited by the constraints on the top package, the bottom package, and their interface. The constraints may include the bottom package being limited to one die, limited input/output (I/O) connections due to perimeter matrix footprint of the top package, and use of customized (non-commodity) more costly memory chips as the top package. This problem may be addressed by an improved system and method for fabricating a semiconductor device having a PoP structure. According to an embodiment, in an improved system and method for fabricating a semiconductor device having a package-on-package structure, a bottom laminate substrate (BLS) is formed to include interconnection patterns (IP) coupled to a plurality of conductive bumps (PCB). A top substrate (TS) is formed to mount a top package by forming a polyimide tape (PT) affixed to a metal layer (ML), and a top die attached to the ML on an opposite side as the PT. A laminate window frame (LWF), which may be a part of the BLS, is fabricated along a periphery of the BLS to form a center cavity. The center cavity enclosed by the BLS, the LWF and the TS houses the top die affixed back-to-back to a bottom die that is affixed to the BLS. The IP formed in the BLS and the LWS provide the electrical coupling between the ML, the top and bottom dies, and the PCB. The fabrication of a semiconductor device having a PoP structure is described with reference to FIGS. 1A, 1B, and 1C.

The following terminology may be useful in understanding the disclosure. It is to be understood that the terminology described herein is for the purpose of description and should not be regarded as limiting.

Semiconductor Package (or Package) - A semiconductor package provides the physical and electrical interface to at least one integrated circuit (IC) or die for connecting the IC to external circuits. The package protects the IC from damage, contamination, and stress that result from factors such as handling, heating, and cooling.

Laminate and Tape Substrates - A substrate is an underlying material used to fabricate a semiconductor device. In addition to providing base support, substrates are also used to provide electrical interconnections between the IC chip and external circuits. Two categories of substrates that are used in ball grid array (BGA) packages for fabricating the semiconductor device include rigid and tape substrates. Rigid substrates are typically composed of a stack of thin layers or laminates, and are often referred to as laminate substrates. The laminate substrate is usually made of polymer-based material such as FR-4 or fiber-reinforced material such as BT (bismaleimide triazine). Tape substrates are typically composed of polymer material such as polyimide, and are often referred to as a polyimide tape substrate. The polyimide tape substrate, which typically includes a single metal layer, is generally cheaper and thinner compared to the multilayer laminate substrate.

Chip Footprint - A chip footprint (or simply the footprint) generally describes the properties of the chip's input/output connections or its contact elements. The properties typically include body size, pitch, number of connections, arrangement of the connections, type of the connection, and similar others. In some chips, space restrictions or constraints such as physical clearances, which may be desired due to a presence of another chip, may limit the arrangement of the contact elements along the peripheral rows of the chip. A chip having a partial or restricted footprint may be limited to having the contact elements arranged in the outer R (R being an integer, e.g., 2 or 3) rows, typically along the perimeter of the chip leaving a particular portion, e.g., a center portion, of the chip clear to accommodate the space restrictions or constraints. A chip having a full matrix footprint is typically free from space restrictions. The full matrix footprint includes contact elements arranged in a two dimensional array that occupies the entire bottom surface of the chip instead of the restricted arrangement. Actual number of contact elements included in the full matrix footprint may be equal to or less than RxC, where R = number of rows, and C = number of columns of the matrix, provided the reduction in the number of contact elements has not been made to comply with the space restrictions. As such, the chip having the full matrix footprint provides greater number of connections compared to the chip having the partial or restricted footprint.

FIG. 1A illustrates a simplified and schematic cross section of a semiconductor device 100 having a package-on-package structure, according to the invention. In the depicted embodiment, the semiconductor device 100 includes a top package 110 having a top ball grid array 112 mounted on a bottom package 120 having a bottom ball grid array 122. Although the top package 110 and the bottom package 120 are each shown with a ball grid array (BGA), other types of packages such as IC chips with leads or leadless, pin grid array (PGA), and land grid array (LGA) are also contemplated. In addition, although the depicted embodiment illustrates the bottom package 120 using wirebonding technology for electrical coupling, FIGS. 1B and 1C describe alternative embodiments of the bottom package 120 using a flipchip interconnection, and a hybrid flipchip/wirebonding interconnection respectively.

As described earlier, the chip footprint describes the properties of the chip's input/output connections or its contact elements. The properties typically include body size, pitch, number of connections, arrangement of the connections, type of the connection, and similar others. In some chips other than the top package 110, space restrictions or constraints such as physical clearances may limit the arrangement of the contact elements along the peripheral rows of the chip. A chip having a partial or restricted footprint may be limited to having the contact elements arranged in the outer R (R being an integer, e.g., 2 or 3) rows, typically along the perimeter of the chip leaving a particular portion, e.g., a center portion, of the chip clear to accommodate the space restrictions or constraints. A chip having a full matrix footprint, e.g., the top package 110, is typically free from space restrictions. The full matrix footprint includes contact elements arranged in a two dimensional array that occupies the entire bottom surface of the chip instead of the restricted arrangement. Actual number of contact elements included in the full matrix footprint may be equal to or less than RxC, where R = number of rows, and C = number of columns of the matrix, provided the reduction in the number of contact elements has not been made to comply with the space restrictions. As such, the chip having the full matrix footprint, e.g., the top package 110, provides greater number of connections compared to the chip having the partial or restricted footprint.

In the depicted embodiment, the semiconductor device 100 includes 4 IC chips or dies, which is two dies each in the top package 110 and the bottom package 120 respectively. In an embodiment, the bottom package 120 is an application specific integrated circuit (ASIC). In an embodiment, the top package 110 is a high volume, low cost, commodity memory multi-chip package (MCP) having a full matrix footprint, although other packages having other types of footprints are also contemplated. Thus, the top package 110 is not constrained by a restricted footprint that may have two rows of contact elements placed along the perimeter.

In the depicted embodiment, a body size of the top package 110 and the bottom package substantially match each other, e.g., 12x12 millimeters. In alternative embodiments, the body sizes may be smaller or larger relative to one another. For example, the body shape may resemble a rectangle having linear dimensions varying approximately between 5 millimeters and 20 millimeters. The body size of the top package 110 may vary (e.g., be smaller or larger) by manufacturer, e.g., 11x11 millimeters, 10x10 millimeters, 10x13 millimeters, 10x12 millimeters, or similar other. A height 104 of the bottom package 120, and the bottom ball grid array 122 is less than 0.6 millimeters. A height 106 of the top package 110, and the top ball grid array 112 is less than 0.8 millimeters. In an embodiment, a combined height 102 of the semiconductor device 100, which includes the heights 104 and 106 of the top package 110, the top ball grid array 112, the bottom package 120, and the bottom ball grid array 122 is less than 1.4 millimeters. In an embodiment, the pitch of the bottom ball grid array 122 may be selected to be one of 0.4 or 0.5 millimeters, and the pitch of the top ball grid array 112 may be selected to be 0.5 or 0.8 millimeters. The bottom ball grid array 122 and the top ball grid array 112 each may also be referred to as a plurality of conductive bumps or solder balls. It is understood, that chip dimensions such as height, length, and width that are described herein are for example purposes, and they may vary by application, and with technology. For example, a height of the semiconductor device 100 may be restricted to 1.4 millimeters in some applications such as thin cellular phones, whereas other applications of the device 100 may not impose such restrictions.

FIG. 1B illustrates a simplified and schematic cross section of a bottom package 124 using a flipchip interconnection, according to an embodiment. FIG. 1C illustrates a simplified and schematic cross section of a bottom package 126 using a combination of flipchip and wirebonding interconnection, according to an embodiment. Referring to FIGS. 1B and 1C, the bottom package 124 includes a top die 136 and a bottom die 134 mounted back-to-back using a flipchip interconnection for both the dies and the bottom package 126 shows the top die 136 using a wirebonding connection mounted back-to-back to the bottom die 134 using a flipchip interconnection. In an example, non-depicted embodiment, the top die 136 may use a flipchip connection and the bottom die 134 may use a wirebonding connection.

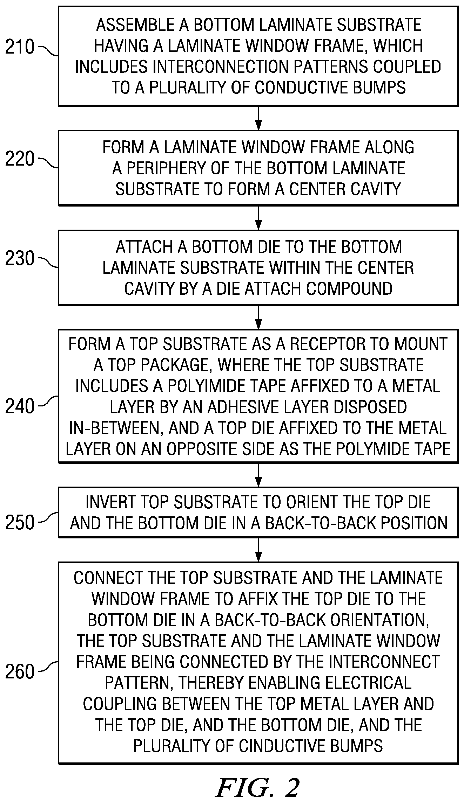

FIG. ID illustrates additional details of a cross section (partial view) of the bottom package 120 of the semiconductor device 100 described with reference to FIG. 1A, according to an embodiment. In an embodiment, the bottom package 120 includes a bottom laminate substrate 130 coupled to the bottom ball grid array 122 via the interconnection patterns 170, a top substrate 140 forming a receptor for the top package (not shown), and a laminate window frame 150 fabricated along a periphery of the bottom laminate substrate 130 to enclose a center cavity 160. In an embodiment, the laminate window frame 150 may be fabricated as part of the bottom substrate 130, or may be added as a separate element during the assembly of the bottom package 120. Additional detail of the fabrication process of the semiconductor device 100 is described with reference to FIG. 2.

The center cavity 160, which is completely enclosed by the bottom laminate substrate 130, the laminate window frame 150, and the top substrate 140 houses the bottom die 134 attached to the bottom laminate substrate 130 by a die attach compound 138, and the top die 136 attached to the top substrate 140 by the die attach compound 138. The top die 136 is affixed back-to-back to the bottom die 134 by the die attach compound 138. In an embodiment, the top die 136 and the bottom die 134 is one of one of a microprocessor, a digital signal processor, a radio frequency chip, a memory, a microcontroller, and a system-on-a-chip or a combination thereof. The bottom laminate substrate 130 includes the interconnection patterns 170 to electrically couple the bottom die 134 to the bottom ball grid array 122 for connection to external circuits (not shown). The interconnection patterns 170 may include various electrical connection techniques such as a conductive adhesive, a thermo compression weld, a high melting point solder contact, a plurality of conductive traces, vias, metal planes, bond wires, metal lands, bond wire areas, and conductive pads.

In an embodiment, the bottom laminate substrate 130 and the laminate window frame 150 are rigid, multi-layer laminate substrates. As described earlier, rigid substrates are typically composed of a stack of thin layers or laminates, and are often referred to as laminate substrates. The laminate substrate is usually made of polymer-based material such as FR-4 or fiber-reinforced material such as BT (bismaleimide triazine). The thickness of the bottom laminate substrate 130 is approximately 150 micrometers, and the thickness of the laminate window frame 150 is approximately 300 micrometers, although thinner or thicker substrates may be possible. In an embodiment, the top substrate 140 includes a polyimide tape 142 (approximately 50 micrometers) affixed to a metal layer 144 (approximately a8 micrometers) by an adhesive layer (not shown). As described earlier, tape substrates are typically composed of polymer material such as polyimide, and are often referred to as a polyimide tape substrate. The polyimide tape substrate, which typically includes a single metal layer, is generally cheaper and thinner compared to the multilayer laminate substrate. It is understood that the thicknesses of the polyimide tape 142 and the metal layer 144 may be thicker or thinner. A plurality of holes 180 is formed in the polyimide tape 142 to expose a plurality of metal lands 182 of the metal layer 144. The polyimide tape 142 is connected to the laminate window frame 150 by the interconnecting patterns 170 that may include one of a conductive adhesive, a thermo compression weld, and a high melting point solder contact, and/or other electrical connection techniques. The top die 136 is attached to the metal layer 144 by the die attach compound 138. Thus, the top die 136 and the polyimide tape 142 are disposed on the opposite sides of the metal layer 144.

FIG. IE illustrates additional details of a cross section (partial view) of the top package 110 mounted on the bottom package 120 of the semiconductor device 100 described with reference to FIGS. 1A and 1B, according to an embodiment. Each one of the plurality of holes 180 that is formed in the polyimide tape 142 provides structural support for an edge 192 of each solder ball of the top ball grid array 112. In addition, each one of the plurality of holes 180 also advantageously provides recesses for the top ball grid array 112 to keep a lower profile, thereby lowering the profile or the height of the top package 110, and hence of the semiconductor device 100. Unlike use of a polymer collar to provide support, which is a well known technique used on some packages where a ring of polymeric material is placed on the surface of the substrate around the base of the ball, the plurality of holes 180 do not use a separate polymer collar to provide the support. The support provided by the plurality of holes 180 advantageously improves the reliability of the connection between the top package 110 and the bottom package 120, especially for the drop test. The plurality of holes 180, and hence the plurality of metal lands 182, are aligned with the top ball grid array 112 for mounting the top package 110.

In an embodiment, the top package 110 may be mounted on the bottom package 120 using a tape automated bonding (TAB) process. The laminate window frame 150 includes additional ones of the interconnection patterns 170, e.g., interconnection patterns 172, which may include various electrical connection techniques such as a conductive adhesive, a thermo compression weld, a high melting point solder contact, a plurality of conductive traces, vias, metal planes, bond wires, metal lands, bond wire areas, and conductive pads, to electrically couple the metal layer 144 to the interconnection patterns 170 and 172, thereby providing interconnection between the top package 110 when mounted on the plurality of metal lands 182, the top and bottom dies 136 and 134, and the bottom ball grid array 122 for connection to external circuits (not shown). The plurality of holes 180 also advantageously provide recesses for top ball grid array 112 to keep a lower profile, thereby resulting in a combined height of the semiconductor device 100 to be less than 1.4 millimeters.

In an embodiment, depending on the intended purpose of the device, the semiconductor device 100 may include one of one of a microprocessor, a digital signal processor, a radio frequency chip, a memory, a microcontroller, and a system-on-a-chip or a combination thereof.

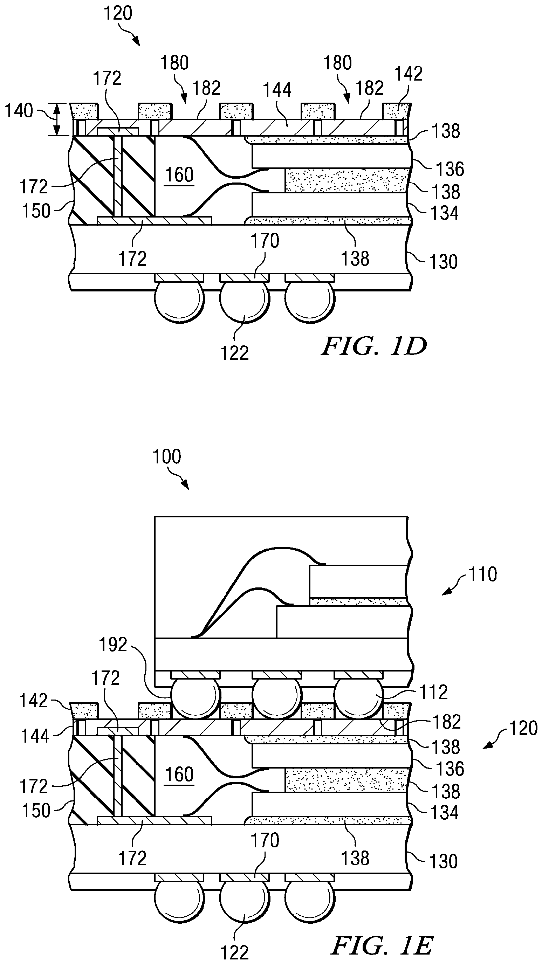

FIG. IF illustrates a sequence to assemble the bottom package 120 described with reference to FIGS. 1A, 1B, 1C, 1D, and 1E, according to an embodiment. In the depicted embodiment, the bottom package 120 is assembled by forming the bottom laminate substrate 130 coupled to the bottom ball grid array 122 via the interconnection patterns 170, attaching the bottom die 134 to the bottom laminate substrate 130 by the die attach compound 138, electrically couple the bottom die 134 by wirebonding to the interconnection patterns 170. The laminate window frame 150 is fabricated along a periphery of the bottom laminate substrate 130 to form the center cavity 160. The die attach compound 138 is applied to the top surface of the bottom die 134.

The top substrate 140, which functions as a receptor for receiving the top package (not shown) is assembled by using a thin film substrate having one metal layer. Specifically, the polyimide tape 142 is affixed to the metal layer 144 by an adhesive layer (not shown) disposed in-between. The plurality of holes 180 is formed in the polyimide tape 142 to expose the plurality of metal lands 182 of the metal layer 144. The top die 136 is attached to the metal layer 144 by the die attach compound 138. Thus, the top die 136 and the polyimide tape 142 having the plurality of holes 180 are disposed on the opposite sides of the metal layer 144. The top package 110 is inverted or flipped to orient the top die 136 towards the center cavity 160. The package 110 in the inverted orientation is electrically coupled to the laminate window frame 150 and the bottom laminate substrate 130 via the interconnection patterns 172 by using one of a conductive adhesive, a thermo compression weld, a high melting point solder contact, and/or other electrical connection techniques. The bottom package 120, when fully assembled, includes the top die 136 attached back-to-back to the bottom die 134 by the die attach compound 138.

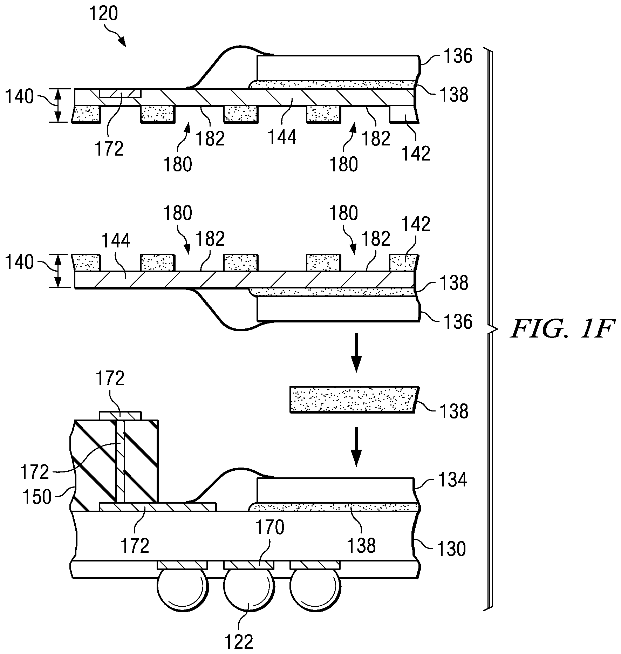

FIG. 2 is a flow chart illustrating a method for fabricating a semiconductor device having a package-on-package structure, according to an embodiment. In a particular embodiment, FIG. 2 illustrates the process for fabricating the semiconductor device 100 described with reference to FIGS. 1A, 1B, 1C, 1D, 1E and 1F. At step 210, a bottom laminate substrate, without the laminate window frame portion is formed. The formation of the bottom laminate substrate includes formation of interconnection patterns coupled to a plurality of conductive bumps. At step 220, a laminate window frame portion of the bottom laminate substrate is formed along a periphery of the bottom laminate substrate to form a center cavity. At step 230, a bottom die is attached by a die attach compound to the bottom laminate substrate within the center cavity. At step 240, a top substrate is formed as a receptor to mount a top package. The top substrate is assembled by using a polyimide tape affixed to a metal layer by an adhesive layer. A top die is affixed to the metal layer on an opposite size as the polyimide tape. At step 250, the top substrate is inverted to orient the top die and the bottom die in a back-to-back position. At step 260, the top substrate is connected to the laminate window frame by a conductive connection such as the interconnection patterns, thereby enabling electrical coupling between the top metal layer, the top die, and the bottom die, and affixing the top die to the bottom die in a back-to-back orientation.

As described earlier with reference to FIG. 1D, the laminate window frame portion and the bottom laminate substrate, which may have different thicknesses, are formed from the same type of rigid, multi-layer laminate substrate. In an embodiment, the laminate window frame may be fabricated as part of the bottom substrate. In this embodiment, step 220 is deleted and merged with step 210. In an alternative embodiment, and as described herein, at step 220 the laminate window frame may be added or fabricated as a separate element during the assembly of the bottom package. As another example, step 240 may be performed in parallel with the steps 210 and 220, provided step 230 is performed before step 260.

Several advantages are achieved by the method and system according to the illustrative embodiments presented herein. The embodiments advantageously provide an improved PoP structure by providing a thin and cost-effective polyimide tape as a receptor for mounting a top package. The center cavity of the bottom package is advantageously capable of housing at least two dies connected to the top and bottom substrates via wire bonding and/or flip chip technologies. Vias formed in the polyimide tape advantageously provide support for the edge of the solder ball that electrically couples the top and the bottom package. The support may advantageously improve the reliability of the solder connection. The plurality of holes also advantageously provide recesses for top ball grid array to keep a lower profile, thereby resulting in a combined height of the semiconductor device to be less than 1.4 millimeters. The combined height may vary on various factors such as the height of the top package 110 and the bottom package, the diameter of the conductive bumps, thickness of the laminates used, and similar others. The top package may be advantageously purchased as a commodity memory package having a standard full matrix footprint. The improved PoP structure also advantageously accommodates top packages of varying body sizes while restricting the overall height.

## Claims

1. A semiconductor device having a package on package structure comprising:
a bottom laminate substrate (130) having a laminate window frame portion (150), wherein the laminate window frame portion is disposed along a periphery of the bottom laminate substrate;
a top substrate (140) mounting a top package (110), the top package having a full matrix footprint, wherein the top substrate includes a polyimide tape (142) affixed to a metal layer (144), and a top die (136) attached to the metal layer on an opposite side as the polyimide tape;
a center cavity (160) enclosed between the bottom laminate substrate, the laminate window frame and the top substrate to house the top die affixed back-to-back to a bottom die (134), the bottom die being affixed to the bottom laminate substrate; and
interconnection patterns (170,172) included in the bottom laminate substrate, the laminate window frame and the center cavity, wherein the interconnection patterns provide electrical coupling between the metal layer, the top die, the bottom die, and a plurality of conductive bumps (122) disposed on a bottom surface of the bottom laminate substrate,
wherein the top substrate includes:
a plurality of holes (180) formed in the polyimide tape, the plurality of holes being arranged in a full matrix array pattern to match the full matrix footprint; and
a plurality of metal lands (182) of the metal layer, wherein each one of the plurality of holes exposes a corresponding one of the plurality of metal lands, wherein the top package having the full matrix footprint is mounted on the plurality of metals lands by means of contact elements (112).

2. The device of Claim 1, wherein each one of the plurality of holes formed in the polyimide tape includes a wall surface, wherein the wall surface in contact with an edge of a contact element of the full matrix footprint provides support for the top package.

3. The device of Claim 1 or 2, wherein the interconnection patterns in the bottom laminate substrate, the laminate window frame and the center cavity include a plurality of conductive traces, vias, metal planes, bond wires, metal lands, conductive pads, a conductive adhesive, a thermo compression weld, and a high melting point solder contact.

4. The device of Claim 1 or 2, wherein at least one of the top die and the bottom die is a die of a microprocessor, a digital signal processor, a radio frequency chip, a memory, a microcontroller, a system-on-a-chip, or a combination thereof.

5. The device of Claim 1 or 2, wherein the device is less than 1.4 millimeters thick.

6. The device of Claim 1 or 2,
wherein the laminate window frame portion is disposed along the periphery of the bottom laminate substrate but is separate from the bottom laminate substrate.

7. The device of Claim 6, wherein a height of the bottom package including the conductive bumps is less than 0.6 millimeters.

8. A method for fabricating a semiconductor device having a package-on-package structure, the method comprising fabrication of the semiconductor device of claim 1 with inclusion of the steps:
assembling a bottom laminate substrate having a laminate window frame portion, wherein forming the bottom laminate substrate includes forming the laminate window frame disposed along a periphery of the bottom laminate substrate to form a center cavity, wherein forming the bottom laminate substrate and the laminate window frame includes forming interconnection patterns to provide electrical coupling;
attaching a bottom die to the bottom laminate substrate within the center cavity;
assembling a top substrate to mount a top package, wherein the top substrate includes a top die attached to a metal layer, the metal layer being affixed to a polyimide tape, wherein the top die is affixed to the metal layer on an opposite side to the polyimide tape;
inverting the top substrate to enable affixing the top die and the bottom die back-to-back; and
connecting the top substrate and the laminate window frame to affix the top die and the bottom die back-to-back, the top substrate and the laminate window frame being connected by the interconnection patterns, thereby enabling electrical coupling between the metal layer, the top die, the bottom die, and a plurality of conductive bumps disposed on a bottom surface of the bottom laminate substrate,wherein the assembling of the top substrate includes:
forming a plurality of holes in the polyimide tape to expose a plurality of metal lands of the metal layer, wherein the plurality of metal lands are arranged in a full matrix array to match the full matrix footprint.

9. The method of Claim 8, further comprising:
mounting the top package on the top substrate, wherein the top package has a full matrix input output (I/O) connection footprint to match the plurality of metals lands to enable the electrical coupling.

## Patentansprüche

1. Halbleiterbauelement mit einer Verpackung-auf-Verpackung-Struktur, aufweisend:
ein unteres Laminatsubstrat (130) mit einem Laminatfensterrahmenabschnitt (150), wobei der Laminatfensterrahmenabschnitt entlang eines Umfangs des unteren Laminatsubstrats angeordnet ist;
ein oberes Substrat (140), auf dem eine obere Verpackung (110) angebracht ist, wobei die obere Verpackung eine Vollmatrixgrundfläche aufweist, wobei das obere Substrat ein Polyimidband (142), das an einer Metallschicht (144) angebracht ist, und einen oberen Chip (136) enthält, der an der Metallschicht auf einer gegenüberliegenden Seite zum Polyimidband angebracht ist;
einen mittigen Hohlraum (160), der zwischen dem unteren Laminatsubstrat, dem Laminatfensterrahmen und dem oberen Substrat eingeschlossen ist, zum Einfassen des oberen Chips, der Rückseite an Rückseite an einem unteren Chip (134) angebracht ist, wobei der untere Chip am unteren Laminatsubstrat angebracht ist; und
Verbindungsprofile (170, 172), die im unteren Laminatsubstrat, im Laminatfensterrahmen und im mittigen Hohlraum enthalten sind, wobei die Verbindungsprofile elektrische Kopplung zwischen der Metallschicht, dem oberen Chip, dem unteren Chip und mehreren leitfähigen Höckern (122) vorsehen, die auf einer Bodenfläche des unteren Laminatsubstrats angeordnet sind,
wobei das obere Substrat enthält:
mehrere Löcher (180), die im Polyimidband ausgebildet sind, wobei die mehreren Löcher in einem Vollmatrixgruppierungsprofil zum Zusammenpassen mit der Vollmatrixgrundfläche angeordnet sind; und
mehrere Metallanschlussflächen (182) der Metallschicht, wobei jedes der mehreren Löcher eine entsprechende der mehreren Metallanschlussflächen freilegt, wobei die obere Verpackung mit der Vollmatrixgrundfläche mithilfe von Kontaktelementen (112) an den mehreren Metallanschlussflächen angebracht ist.

2. Bauelement nach Anspruch 1, wobei jedes der mehreren Löcher, die im Polyimidband ausgebildet sind, eine Wandfläche beinhaltet, wobei die Wandfläche in Kontakt mit einer Kante eines Kontaktelements der Vollmatrixgrundfläche Unterstützung für die obere Verpackung vorsieht.

3. Bauelement nach einem der Ansprüche 1 oder 2, wobei die Verbindungsprofile im unteren Laminatsubstrat, im Laminatfensterrahmen und im mittigen Hohlraum mehrere leitfähige Bahnen, Durchkontaktierungen, Metallebenen, Bonddrähte, Metallanschlussflächen, leitfähige Kontaktstellen, einen leitfähigen Haftstoff, eine Thermokompressionsschweißung und einen Lötkontakt mit hohem Schmelzpunkt enthalten.

4. Bauelement nach einem der Ansprüche 1 oder 2, wobei mindestens einer des oberen Chips und des unteren Chips ein Chip eines Mikroprozessors, eines digitalen Signalprozessors, eines Funkfrequenzchips, eines Speichers, einer Mikrosteuerung, eines System-on-a-Chip oder einer Kombination davon ist.

5. Bauelement nach einem der Ansprüche 1 oder 2, wobei das Bauelement weniger als 1,4 Millimeter stark ist.

6. Bauelement nach einem der Ansprüche 1 oder 2, wobei der Laminatfensterrahmenabschnitt entlang des Umfangs des unteren Laminatsubstrats angeordnet ist, jedoch vom unteren Laminatsubstrat getrennt ist.

7. Bauelement nach Anspruch 6, wobei eine Höhe der unteren Verpackung einschließlich der leitfähigen Höcker weniger als 0,6 Millimeter beträgt.

8. Verfahren zum Herstellen eines Halbleiterbauelements mit einer Verpackung-auf-Verpackung-Struktur, das Verfahren aufweisend die Herstellung des Halbleiterbauelements nach Anspruch 1 unter Einbeziehung der folgenden Schritte:
Montieren eines unteren Laminatsubstrats mit einem Laminatfensterrahmenabschnitt, wobei das Ausbilden des unteren Laminatsubstrats das Ausbilden des Laminatfensterrahmens entlang eines Umfangs des unteren Laminatsubstrats angeordnet enthält, um einen mittigen Hohlraum auszubilden, wobei das Ausbilden des unteren Laminatsubstrats und des Laminatfensterrahmens das Ausbilden von Verbindungsprofilen zum Vorsehen von elektrischer Kopplung enthält;
Anbringen eines unteren Chips am unteren Laminatsubstrat innerhalb des mittigen Hohlraums;
Montieren eines oberen Substrats zum Anbringen einer oberen Verpackung, wobei das obere Substrat einen oberen Chip enthält, der an einer Metallschicht angebracht ist, wobei die Metallschicht an einem Polyimidband angebracht ist, wobei der obere Chip an der Metallschicht auf einer gegenüberliegenden Seite zum Polyimidband angebracht ist;
Umkehren des oberen Substrat, um das Anbringen des oberen Chips und des unteren Chips Rückseite an Rückseite zu ermöglichen; und
Verbinden des oberen Substrats und des Laminatfensterrahmens zum Anbringen des oberen Chips und des unteren Chips Rückseite an Rückseite, wobei das obere Substrat und der Laminatfensterrahmen durch die Verbindungsprofile verbunden werden, wodurch eine elektrische Kopplung zwischen der Metallschicht, dem oberen Chip, dem unteren Chip und mehreren leitfähigen Höckern ermöglicht wird, die auf einer Bodenfläche des unteren Laminatsubstrats angeordnet sind, wobei das Montieren des oberen Substrats beinhaltet:
Ausbilden von mehreren Löchern im Polyimidband zum Freilegen von mehreren Metallanschlussflächen der Metallschicht, wobei die mehreren Metallanschlussflächen in einer Vollmatrixgruppierung zum Zusammenpassen mit der Vollmatrixgrundfläche angeordnet sind.

9. Verfahren nach Anspruch 8, ferner aufweisend:
Anbringen der oberen Verpackung auf dem oberen Substrat, wobei die obere Verpackung eine Vollmatrix-Eingang/Ausgang- (I/O-) Verbindungsgrundfläche zum Zusammenpassen mit den mehreren Metallanschlussflächen zum Ermöglichen von elektrischer Kopplung aufweist.

## Revendications

1. Dispositif semi-conducteur ayant une structure de boîtier sur boîtier comprenant :
un substrat inférieur stratifié (130) ayant une partie de cadre de fenêtre stratifié (150), la partie de cadre de fenêtre stratifié étant disposée le long d'une périphérie du substrat inférieur stratifié ;
un substrat supérieur (140) sur lequel est monté un boîtier supérieur (110), le boîtier supérieur ayant une empreinte de matrice complète, le substrat supérieur comportant un ruban de polyimide (142) fixé à une couche métallique (144), et une puce supérieure (136) attachée à la couche métallique sur un côté opposé à celui du ruban de polyimide ;
une cavité centrale (160) enfermée entre le substrat inférieur stratifié, le cadre de fenêtre stratifié et le substrat supérieur pour accueillir la puce supérieure fixée dos à dos à une puce inférieure (134),
la puce inférieure étant fixée au substrat inférieur stratifié ; et
des motifs d'interconnexion (170, 172) contenus dans le substrat inférieur stratifié, le cadre de fenêtre stratifié et la cavité centrale, les motifs d'interconnexion assurant un couplage électrique entre la couche métallique, la puce supérieure, la puce inférieure, et une pluralité de plots conducteurs (122) disposés sur une surface inférieure du substrat inférieur stratifié,
le substrat supérieur comportant :
une pluralité de trous (180) formés dans le ruban de polyimide, la pluralité de trous étant disposés en un motif de réseau matriciel complet pour correspondre à l'empreinte de matrice complète ; et
une pluralité de plages d'accueil métalliques (182) de la couche métallique, chaque trou de la pluralité de trous exposant une plage d'accueil correspondante de la pluralité de plages d'accueil métalliques, le boîtier supérieur ayant l'empreinte de matrice complète étant monté sur la pluralité de plages d'accueil métalliques au moyen d'éléments de contact (112) .

2. Dispositif de la revendication 1, dans lequel chaque trou de la pluralité de trous formés dans le ruban de polyimide comporte une surface de paroi, la surface de paroi en contact avec un bord d'un élément de contact de l'empreinte de matrice complète fournissant un support pour le boîtier supérieur.

3. Dispositif de la revendication 1 ou 2, dans lequel les motifs d'interconnexion dans le substrat inférieur stratifié, le cadre de fenêtre stratifié et la cavité centrale comportent une pluralité de traces conductrices, des trous d'interconnexion, des plans métalliques, des fils de connexion, des plages d'accueil métalliques, des pastilles conductrices, un adhésif conducteur, une soudure par thermocompression, et un contact brasé à haut point de fusion.

4. Dispositif de la revendication 1 ou 2, dans lequel au moins une puce entre la puce supérieure et la puce inférieure est une puce d'un microprocesseur, un processeur de signal numérique, une puce radiofréquence, une mémoire, un microcontrôleur, un système sur puce, ou une combinaison de ceux-ci.

5. Dispositif de la revendication 1 ou 2, le dispositif faisant moins de 1,4 millimètre d'épaisseur.

6. Dispositif de la revendication 1 ou 2, dans lequel la partie de cadre de fenêtre stratifié est disposée le long de la périphérie du substrat inférieur stratifié, mais est séparée du substrat inférieur stratifié.

7. Dispositif de la revendication 6, dans lequel une hauteur du boîtier inférieur comportant les plots conducteurs est inférieure à 0,6 millimètre.

8. Procédé de fabrication d'un dispositif semi-conducteur ayant une structure de boîtier sur boîtier, le procédé comprenant la fabrication du dispositif semi-conducteur de la revendication 1 avec inclusion des étapes :
assemblage d'un substrat inférieur stratifié ayant une partie de cadre de fenêtre stratifié, la formation du substrat inférieur stratifié comportant la formation du cadre de fenêtre stratifié disposé le long d'une périphérie du substrat inférieur stratifié pour former une cavité centrale, la formation du substrat inférieur stratifié et du cadre de fenêtre stratifié comportant la formation de motifs d'interconnexion pour assurer un couplage électrique ;
fixation d'une puce inférieure au substrat inférieur stratifié à l'intérieur de la cavité centrale ;
assemblage d'un substrat supérieur pour monter un boîtier supérieur, le substrat supérieur comportant une puce supérieure attachée à une couche métallique, la couche métallique étant fixée à un ruban de polyimide, la puce supérieure étant fixée à la couche métallique sur un côté opposé à celui du ruban de polyimide ;
retournement du substrat supérieur pour permettre la fixation de la puce supérieure et de la puce inférieure dos à dos ; et
raccordement du substrat supérieur et du cadre de fenêtre stratifié pour fixer la puce supérieure et la puce inférieure dos à dos, le substrat supérieur et le cadre de fenêtre stratifié étant raccordés par les motifs d'interconnexion, permettant ainsi un couplage électrique entre la couche métallique, la puce supérieure, la puce inférieure, et une pluralité de plots conducteurs disposés sur une surface inférieure du substrat inférieur stratifié, l'assemblage du substrat supérieur comportant :
la formation d'une pluralité de trous dans le ruban de polyimide pour exposer une pluralité de plages d'accueil métalliques de la couche métallique, la pluralité de plages d'accueil métalliques étant disposées en un réseau matriciel complet pour correspondre à l'empreinte de matrice complète.

9. Procédé de la revendication 8, comprenant en outre :
le montage du boîtier supérieur sur le substrat supérieur, le boîtier supérieur ayant une empreinte de connexion d'entrée/sortie (I/O) de matrice complète pour correspondre à la pluralité de plages d'accueil métalliques pour permettre le couplage électrique.
